# EUROPÄISCHE PATENTANMELDUNG

(11) **EP 2 884 829 A1**
(43) Veröffentlichungstag der Anmeldung: **17.06.2015**
(21) Anmeldenummer: 13464022.6
(22) Anmeldetag: 12.12.2013
(51) Int. Cl.: H05K 7/20

(54) **Gehäuse**

(71) Anmelder: Continental Automotive GmbH, 30165 Hannover (DE)
(72) Erfinder: Muresan, Daniel, 307220 Giroc (RO); Lukacsel, Mihai, 330007 Deva (RO)

(57) **Zusammenfassung**

Gegenstand der Erfindung ist ein Gehäuse für eine Motorsteuerung in einem Kraftfahrzeug, umfassend einen Boden 1 und einen Deckel 2, eine darin angeordnete Elektronik, Mittel zum dichten Verbinden von Boden 1 und Deckel 2 und Mittel zum Kühlen des Gehäuses. In dem Gehäuse eine Kühlmittelleitung 6 angeordnet, welche von dem Gehäuse umschlossen ist.

## Beschreibung

Gegenstand der Erfindung ist ein Gehäuse für eine Motorsteuerung in einem Kraftfahrzeug, umfassend einen Boden und einen Deckel, eine darin angeordnete Elektronik, Mittel zum dichten Verbinden von Boden und Deckel und Mittel zum Kühlen des Gehäuses.

Derartige Gehäuse werden als Motorsteuergehäuse in Kraftfahrzeugen eingesetzt und sind somit bekannt. Mittels der Motorsteuerelektronik wird einer Vielzahl von Funktionen im Kraftfahrzeug, vorrangig die des Verbrennungsmotors, gesteuert. Die dabei entstehende Wärme muss zum Schutz der Elektronik abgeführt werden. Dazu ist es bekannt, zumindest einen der Gehäusebestandteile mit Kühlrippen zu versehen, über die die von der Elektronik erzeugte Wärme an die Umgebung ab-gegeben werden kann. Neben dieser passiven Gehäusekühlung ist auch eine aktive Kühlung bekannt. In dem Gehäuse ist dazu eine Leitung, vorzugsweise aus Metall, montiert, die von einem Kühlmittel durchflossen wird. Sowohl zur Halterung als auch um einen Kontakt für den Wärmeübergang vom Gehäuse zur Kühlleitung herzustellen, ist die Kühlleitung an einigen Stellen mittels Halteblechen am Gehäuse verschraubt. Zusätzlich wird die Kühlmittelleitung noch verklebt. Nachteilig ist, dass der Montageaufwand zur Befestigung der Kühlmittelleitung. Die beste Kühlwirkung wird an den Befestigungsstellen erzielt. In den anderen Bereichen ist die Kühlwirkung weniger ausgeprägt.

Der Erfindung liegt daher die Aufgabe zugrunde, ein Gehäuse der eingangs genannten Art zu schaffen, bei dem mit geringem Aufwand eine effektive Kühlung gegeben ist.

Gelöst wird die Aufgabe dadurch, dass in dem Gehäuse eine Kühlmittelleitung angeordnet ist, welche von dem Gehäuse umschlossen ist.

Mit der vollständig vom Gehäuse umschlossenen Kühlmittelleitung, wird ein deutlich verbesserter Wärmeübergang vom Gehäuse zur Kühlmittelleitung erzielt, wodurch die Kühlleistung deutlich verbessert wird. Die verbesserte Kühlleistung ermöglicht einen größeren Wärmeeintrag seitens der Elektronik, so dass diese mit höheren Leistungen betrieben werden kann oder mehr Elektronikkomponenten im Gehäuse untergebracht werden können. Bleiben dagegen die Anforderungen an die Kühlung gleich, erlaubt die verbesserte Kühlung die Verwendung einer Kühlmittelleitung mit kleinerem Querschnitt, so dass das erfindungsgemäße Gehäuse weniger Bauraum benötigt. Ein weiterer Vorteil besteht darin, dass infolge der Integration der Kühlmittelleitung in das Gehäuse eine zusätzliche Montage entfällt. Das Gehäuse ist somit kostengünstiger herstellbar.

In einer vorteilhaften Ausgestaltung ist die Wandung der Kühlmittellleitung von einem Metallrohr gebildet. Mit dem separaten Rohr kann dieses bei einem mittels Gießen herstellbaren Gehäuse während des Gießprozesses in das Gehäuse, insbesondere in eines der beiden Gehäusehälften, integriert werden. Dadurch entfällt das nachträgliche mechanische Einbringen des Heiz- oder Kühlkanals, welches wesentlich mehr Aufwand erfordert.

In einer anderen Ausgestaltung ist die Wandung der Kühlmittelleitung von dem Gehäuse gebildet. Mit dem Wegfall des Metallrohres besitzt das Gehäuse ein geringeres Gewicht.

In einer weiteren vorteilhaften Ausgestaltung besitzen Boden und Deckel Ausnehmungen zur Aufnahme der Kühlmittelleitung. Diese Ausgestaltung erlaubt das nachträgliche Einlegen eines Metallrohres in eine der beiden Gehäusehälften und das anschließende Verbinden von Deckel und Boden zum fertigen Gehäuse. Dadurch muss die Kühlmittelleitung nicht bereits bei der Herstellung der Gehäusehälften bereitgestellt werden. Die Verwendung eines Metallrohres als Kühlmittelleitung hat zudem den Vorteil, dass die Leitung nicht vom Gehäuse gebildet wird, was ein aufwändiges Abdichten der beiden Gehäusehälften zur Folge hätte.

Des Weiteren kann bei gegossenen Gehäusen auf den Einsatz von Kernen verzichtet werden, was die Herstellung deutlich vereinfacht. Es ist aber auch denkbar die Ausnehmungen in einem separaten Arbeitsgang in die jeweiligen Gehäusehälften einzubringen.

Eine leichtere Montage wird erreicht, wenn die Enden der Kühlmittelleitung zum Anschluss einer Leitung ausgebildet sind.

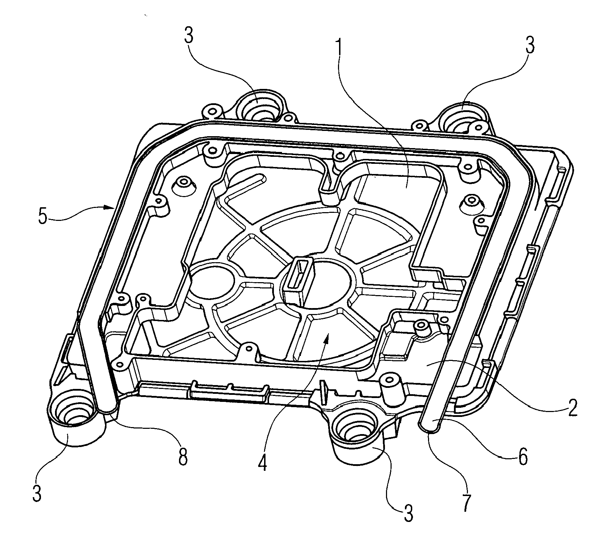

An einem Ausführungsbeispiel wird die Erfindung näher beschrieben. Die einzige Figur zeigt das aus einem Boden 1 und einem Deckel 2 bestehende Gehäuse, wobei Deckel 2 und Boden 1 miteinander verschraubt sind. Über am Deckel 2 angeformte Verbindungslaschen 3 lässt sich das Gehäuse in einem Kraftfahrzeug befestigen. Zur besseren Darstellung ist der Deckel 2 geschnitten dargestellt, so dass der freiliegende Innenbereich 4 zu sehen ist, der für die Anordnung einer Motorsteuerungselektronik vorgesehen ist. Der Innenbereich 4 ist von einem im Gehäuse verlaufenden Kanal 5 umgeben, in dem ein Metallrohr 6 angeordnet ist. Das Metallrohr 5 ist Teil des Kühlsystems und ist in den Deckel 2 eingegossen. Über die Anschlüsse 7, 8 lässt sich das Metallrohr 5 mit dem Kühlsystem verbinden.

## Patentansprüche

1. Gehäuse für eine Motorsteuerung in einem Kraftfahrzeug, umfassend einen Boden und einen Deckel, eine darin angeordnete Elektronik, Mittel zum dichten Verbinden von Boden und Deckel und Mittel zum Kühlen des Gehäuses, **dadurch gekennzeichnet, dass** in dem Gehäuse eine Kühlmittelleitung (6) angeordnet ist, welche von dem Gehäuse umschlossen ist.

2. Gehäuse nach Anspruch 1, **dadurch gekennzeichnet, dass** die Wandung der Kühlmittellleitung von einem Metallrohr (6) gebildet ist.

3. Gehäuse nach Anspruch 1, **dadurch gekennzeichnet, dass** die Wandung der Kühlmittelleitung von dem Gehäuse gebildet ist.

4. Gehäuse nach zumindest einem der vorhergehenden Ansprüche, **dadurch gekennzeichnet, dass** die Kühlmittelleitung (6) im Boden (1) oder Deckel (2) des Gehäuses angeordnet ist.

5. Gehäuse nach Anspruch 2, **dadurch gekennzeichnet, dass** Boden (1) und Deckel (2) Ausnehmungen zur Aufnahme der Kühlmittelleitung (6) besitzen.
